# EUROPEAN PATENT APPLICATION

(11) **EP 2 022 905 A1**
(43) Date of publication of application: **11.02.2009**
(21) Application number: 07788543.2
(22) Date of filing: 13.04.2007
(51) Int. Cl.: E04C 2/22

(54) **DEVICE FOR PARTITIONING AND CLOSURES OF VERTICAL TYPE**

(30) Priority: 18.04.2006 ES 200601200
(71) Applicant: Puig Gonzalez, Pedro, 04720 Aguadulce - Almeria (ES)
(72) Inventor: Puig Gonzalez, Pedro, 04720 Aguadulce - Almeria (ES)
(74) Representative: Urizar Anasagasti, Jesus Maria
(86) International application number: PCT/ES2007/000225
(87) International publication number: WO 2007/118916

(57) **Abstract**

Device for partitioning and closures of vertical type, which comprises a series of reinforcements of board form consisting of a panel (1) or various contiguous panels, totally or partially surrounded with profiling (2-4), which have, on their faces, a plurality of channels (11) made in their surface and forming a relief that serves as a key for cement or mortar or plaster (6), and, depending on the panels used, this element may serve as thermal, acoustic or electromagnetic insulation, as shielding or as protection against radiation of any type.

## Description

### Object of the Invention

The invention is comprised within the technical field of construction for erecting indoor and outdoor partitioning, walls, façades and any closure of vertical type in the construction of buildings. This invention intends improving the current way of constructing, covering spaces without needing bricks, using reinforcements which are easier and quicker to place.

### Background of the Invention

Since ancient times, man has attempted to shelter himself from the inclemency of the weather in his own constructions. In the beginning, the raw material available for him to start building was scarce, based on stones and puddle. Since the Assyrians, who invented bricks, until today, any construction is formed by prefabricated elements, duly assembled, connected or adhered when carrying out the work. Thus, not only bricks, but joists, arches, pavements, wall tiles, roofing tiles and other installations, etc. have been prefabricated before their subsequent assembly.

The arrangement, assembly, connection and coordination of these elements forms the action for constructing the building, it is more expensive the higher the number of connections and adjustments to be made; or in other words, the smaller the prefabricated elements, the higher the number of connections contemplated. In the past, things were made smaller so that the human effort in moving and lifting them were smaller. The selection of construction materials is currently more varied and there is a wide range of possibilities from which to choose. Therefore, and based on that inferred from the foregoing, more lightweight materials are preferred in order to able to increase their size.

The present invention complies with these requirements and furthermore, its installation is simple and easy.

### Description of the Invention

The invention relates to reinforcements of board form consisting of a panel or various contiguous panels, totally or partially surrounded with profiling, with the aim of serving as a key for the cement or for the plastering mortar. These panels are made of expanded polystyrene (porexpan) or another synthetic material, or a combination of these materials with others of a metal nature forming an inner structure; such that they allow covering the needs of each time, i.e. as thermal, acoustic, electromagnetic insulation, protection against radiation of any type, or even shielding.

These panels have on their faces a plurality of channels made in their surface and forming a relief facilitating the fixing of the cement or mortar on their surface. A mesh like a grid can optionally be arranged in this relief, which mesh contributes to the fixing of the coating cement or mortar. The section of the grooves existing on the faces of the panels, through which the cement can be introduced preferably has a section according to the Greek letter omega. Likewise, it has provided that the reinforcements have holes in their panels with a diameter sufficient for the cement of both outer faces to make contact, in which clamp or clip type structural elements can be introduced, which elements would be embedded in the cement or mortar.

According to another feature of the present invention, the profiles surrounding the panels have a section according to the Greek letter omega, in which the central slot corresponds to the thickness of the panel fitted therein, whereas the side ends project perpendicular to the panel, serving as a rule in the plastering, being adjusted to the suitable thickness and breadth of the cement or mortar to be placed. These profiles are not smooth and have holes or small orifices so that the cement is secured therein.

These profiles are assembled to one another by means of squares fitted at the outside, which squares have an anchoring means formed by a toothed tab which is supported on the base of the profile, which tab, upon being introduced, is fitted on saw-toothed notches made in the outer base of the squares.

Both the profiles and the squares have flanges spaced from one another, which are orthogonally bent so that they are supported on the concrete surface and can thus be fixed therein by means of plugs and screws.

It has also been provided that the openings allowing the passage in the profiles, or in the squares, of electricity and plumbing supply lines will be formed by a series of successively annexed and inverted triangles, with a gap between them, for the purpose of preventing a weakening of the inner structure of the profile, while at the same time they allow enlarging the necessary opening by simply removing the separation gap between every two triangles.

The connection or anchoring between reinforcements is carried out with rivets, made in the profiles, after joining and placing the reinforcements. When it is necessary to fix two reinforcements in a corner, an arrow tip-shaped corner profile is available, the central segment of which is arranged in the diagonal dividing each plasterwork face according to the orthogonal emergence of the omega-shaped profiles, for the purpose of serving as a rule and facilitating the plastering of the reinforcements.

### Description of the Drawings

To complement the description which is being made and for the purpose of aiding to better understand the features of the invention, a set of drawings is attached to this specification in which the following has been shown with an illustrative and non-limiting character:

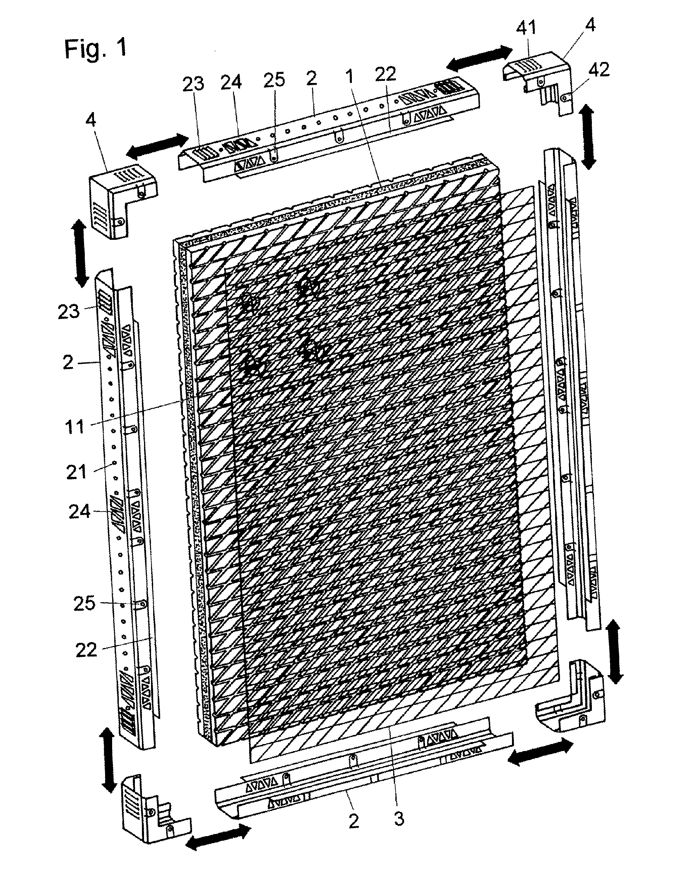

Figure 1 shows a general perspective view of a reinforcement, formed by a panel (1) and a series of metal profiles (2) and (4) in an extended position.
Figure 2 shows a section view of one of the profiles (2).
Figure 3 shows a section according to a horizontal plane of a connection of reinforcements carried out in this case forming a right angle.

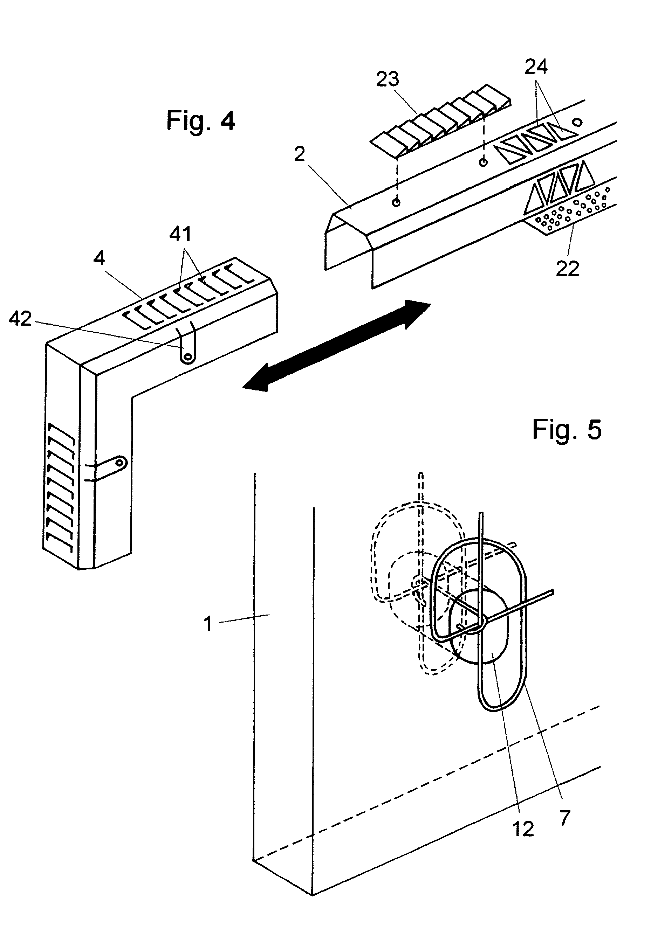

Figure 4 shows the connection between a straight profile (2) and another corner profile (4).
Figure 5 shows a detail of one of the orifices (12) made in the panel (1) to contact the coating cement of both faces, provided in this case with a metal hook as a reinforcement.

### Preferred Embodiment of the Invention

As can be observed in the referenced figures, the device for partitioning and closures of vertical type, either for erecting indoor and outdoor partitions, walls, façades and any closure of vertical type in the construction of buildings, even construction furniture, comprises a series of reinforcements of board form consisting of a panel (1), or various contiguous panels, totally or partially surrounded with profiling (2), fitted in one another, aligned or in a corner, forming the divisional faces of a building.

These panels (1) have on both outer faces a geometric relief (11) preventing the detachment of the cement or plaster and which will facilitate its fixing. This relief defines an omega-shaped section of the grooves (11) in which the cement is introduced.

It has been verified in practice that on a panel (1) made of expanded polystyrene, apparently unsuitable for this purpose, with a thickness of 5 cm, on which said relief has been traced and made on both faces, the cement or the plaster grips perfectly in the vertical direction, whereby it is concluded that it will likewise do so on any other surface suitable for this purpose,- i.e., what is important is the relief and not the texture and composition, although the dilations of the surface serve as a support. This circumstance is the basis and essence of the invention.

One aspect to take into account in this invention lies in the method or way in which the reinforcement is removed. Once the passages or grooves suitable for plumbing and electricity supply lines have been previously opened, a first layer or coat is applied with a trowel to provide the reinforcement with consistency and it is allowed to dry. Subsequently, it is plastered by a usual procedure, by means of a square-pointed trowel or if preferred, with a trowel. Conventional partitioning also requires time in order to start plastering. It is very comfortable to open passages for plumbing and electricity supply lines in panels made of expanded polystyrene with any hot metal bar.

The reinforcements will have holes (12) in their panels so that the cement or mortar (6) of both outer faces makes contact and a mesh (3) like a grid may be arranged on the aforementioned relief. With both elements, the assembly is provided with unity, firmness, rigidity and the cement neither splits nor cracks. In the tests conducted, it is observed that this mesh and the holes can be dispensed with when thick layer mortar is used instead of cement.

Wrought irons (7) are introduced through the holes (12), which wrought irons are of the type used for formwork and are bent as if they were a clamp to attach the ends. These ends are of the same iron and are bent such that they outline three quarters of a circumference, which is closed by assembling it on itself and forms a cross at its center, where the mentioned clamps will be attached, in order to press on the panels and keep them connected. This assembly of two ends, connected by an iron in the form of clamp attaching them and the cement which is applied, forms a conducting rib between the two outer faces of the reinforcement, joining them to provide rigidity. The holes with the irons are spaced from one another about 30 cm, as if they were the vertices of a square.

As has been stated, the profiles (2-4) surround a panel, or various panels, forming the reinforcement. The anchoring between reinforcement is carried out by means of rivets (8), i.e., upon joining and placing the reinforcement, the profiles which are faced will be riveted.

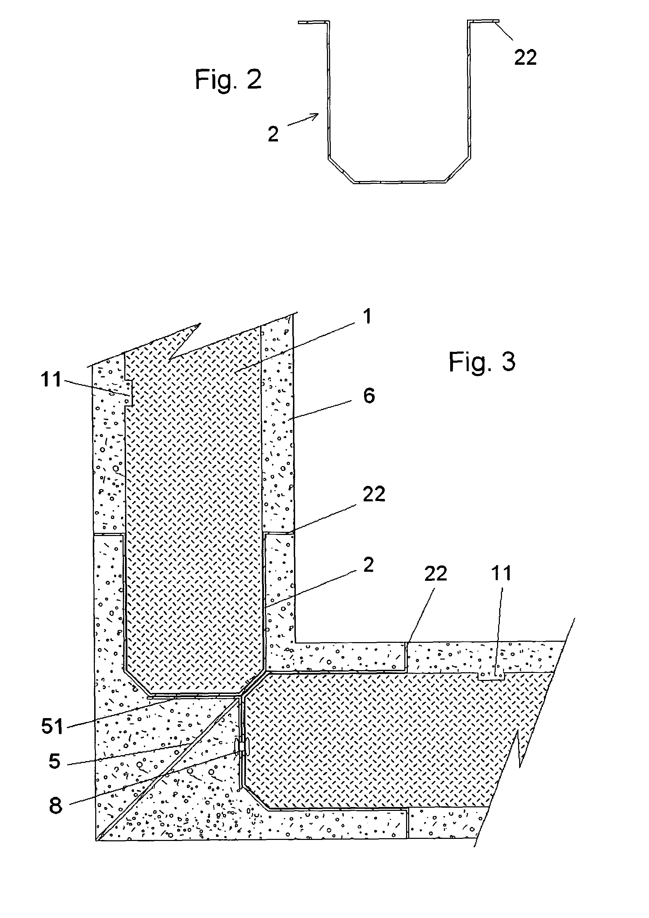

In said profiles (2), which in section view have the shape of the Greek letter omega (Ω), the side ends (22) project to serve as a rule and facilitate the plastering of said panels, being adjusted to the suitable thickness and breadth of the cement, plaster or mortar. The central part of the letter omega, which is U-shaped, is fitted on the panels (1) and has five faces (see Figure 2), which allows connecting not only two panels in an aligned manner but also in a corner (see Figure 3), being able to rivet their faces in both cases. This shape of the profile also allows, upon plastering two aligned reinforcements, the cement to penetrate and settle in the V-shaped cleft opened between them.

When the profiles (2-4) for facilitating the plastering of the reinforcements are not arranged, in certain cases rules with spikes are used which can be driven into and supported on the surface of the reinforcements, in a manner of use similar to the side ends of the omega-shaped profiles projecting perpendicularly to the reinforcement.

In the case of the connection of two profiles in a corner, as shown in detail in Figure 3, another profile (5) with orifices (21) is inserted so that the cement is secured therein, which profile has a segment in an angle (51) and a diagonal longitudinal segment dividing it into two equal parts of 45°, so that it serves as a rule and facilitates the plastering of the two reinforcements in a corner. Therefore, the size of the diagonal segment must be in line with that of the plastering of the panels. These profiles are not smooth, they will have holes or small orifices so that the cement or the plaster is secured.

Other more considerable openings (24) allow the passage of electricity and plumbing supply lines and are a series of equilateral or isosceles triangles, as appropriate, arranged one after the other, facing identical sides in parallel and leaving a gap between them. It is thus achieved that the inner structure of the profile is not weakened and in addition, if the opening is to be enlarged, it can be done so easily, removing the separation gap between every two triangles with the aid of pincers.

The profiles corresponding to the longest segments of the reinforcement provide access to the supply lines only at the upper part, at the lower part and in the middle with an equidistant separation between them. The profiles corresponding to the shortest segments of the reinforcement will provide access to the supply lines close to the two ends of the profile.

The anchoring of the reinforcements with the concrete surfaces will be carried out by means of blocks and screws. To that end, the profiles will have flanges (25-42) designed for such purpose, which can be bent and supported on the concrete with an equidistant separation between them of about 25 cm.

The anchoring of these reinforcements with metal surfaces such as structures and beams, is carried out if possible by means of rivets or screws suitable for that purpose and if not, by welding stoppers along the beams on both faces of the profile so that the reinforcement is not moved from its place.

Each reinforcement is structured by four corner profiles (4) and as many other straight profiles (2) forming stringers and struts of said reinforcement. The straight profiles (2) and the squares (4) are assembled to one another by means of a toothed tab (23) which is supported on the outer base of the profile (2) which, upon being introduced, is fitted in saw toothed notches (41), formed in the squares (4) .

The dimensions of the reinforcements, which initially are unique, therefore they must be adapted to the space to be covered when carrying out the work. This is why the squares (4) can be removed and again assembled easily, once the profiles have been cut to the desired measurement. There are scissors on the market which cut profiling perfectly. When the profiles are cut so that they enter through the slit of the square, their projecting side segments must be removed, which segments, as stated, serve as a rule and facilitate the plastering of the panels. The tab (23) is removed and again inserted on the outer base of the section of the new profile. To that end, it has two bosses which are introduced in orifices made for such purpose, during the manufacture and throughout the face of the profile. The panels are cut with a handsaw and the profiling will again be fitted in them.

To assemble these reinforcements, measurements must be taken upon starting the work and since the reinforcements initially have unique measurements (270 x 80 cm), they will have to be duly adapted to them, placing the reinforcements one by one. If the height of the wall exceeds 3 meters, the missing piece will be added with that of another reinforcement, connecting their profiles with rivets. These connections will alternate above and below such that they never coincide, so that the assembly is not weakened.

In order to cut the profiles and the panels, the squares (4) must be previously removed. The squares are removed upon pressing the toothed tab acting as an anchor. The profiles are cut with special scissors available for that purpose on the market and the panels are cut with a handsaw.

The reinforcements are fixed to the concrete surfaces or any other surface by means of blocks and screws.

Before connecting the profiling again and reforming the reinforcement, one of the longest profiles is placed vertically with squares fitted in its ends, on the concrete surface or any other similar surface and it is secured thereto with screws and blocks. Holes made with a drill will be used as gripping points, preferably inside the "U" of the profile and of the squares; which holes are located where it is suitable to apply screws.

The tabs are subsequently inserted in the profiles to assemble the reinforcement with the squares of the profile which was previously secured to the concrete surface. The side anchoring of the reinforcement is thus achieved and the upper and lower anchoring is achieved by means of the flanges of its profiles.

The equidistant flanges included in the profiles every 25 cm will be used when it is not possible to make inner holes such as those mentioned. This occurs when the profiling of both sides of the reinforcement is to be fixed with screws and from the inside, because they are fitted in the tabs of one side of the reinforcement or on the other side, it being impossible to anchor the four tabs at the same time in their respective squares.

Once the first reinforcement is anchored, the process is continued with the next one and the same operation is carried out as with the previous one, with the difference that the profile which is faced is riveted instead of screwed.

The rivets (8) are preferably applied inside the "U" of the profiles and of the squares and if not, on flanges which are bent until being supported on the contiguous profile.

Therefore, all the reinforcements are connected to one another by riveting the profiles which are faced. If more than two are faced, an intersection is formed and to provide the assembly with consistency, the first and second profile are riveted in the usual manner and in the following profiles, their rivets must be applied in an alternate manner on the two previous ones.

The preframes and frames of the doors and windows will be fixed with screws to the profiles of the reinforcements surrounding them, either from inside the "U" of the profile by means of their flanges or directly on the preframes.

The electricity and plumbing supply lines are opened with any cutter or sharp tool and if the situation is favorable, the panel is melted with a hot metal bar.

Horizontal supply lines prevail over vertical supply lines in order to not damage the structural solidity.

In the plumbing, the weld points of the copper installations are not a problem when a screen like a shield made of asbestos or any other fireproof material is placed between the panel and the pipe.

Once the suitable passages and grooves for plumbing and electricity supply lines, a first layer or coat of cement of cement is applied with a trowel to provide the reinforcement with consistency and it is allowed to dry. The passages will be free of cement until the installations are ready.

An attempt must be made to ensure that in this first coat all the groves providing relief to the outer surfaces of the reinforcements and the holes communicating both outer faces are covered and filled.

If the reinforcement is to be plastered with mortar, the first coat must be applied with adhesive cement due to ease and adherence. It is subsequently plastered by the usual procedure with a square-pointed trowel and if preferred, with a trowel, leveling with the aid of the side ends of the profiles which project to serve as a rule.

## Claims

1. A device for partitioning and closures of vertical type, for erecting indoor and outdoor partitions, walls, façades and any closure of vertical type in the construction of buildings and construction furniture, **characterized in that** comprising a series of reinforcements of board form consisting of a panel or various contiguous panels (1) made of expanded polystyrene (porexpan) or another synthetic material, or a combination of these materials with others of a metal nature forming an inner structure to the whole; said panels (1) totally or partially surrounded with profiling (2-4), have on their faces a plurality of channels (11) made on their surface, that forming a relief that serves as a key for coating cement or mortar or plaster (6), being this element a thermal, acoustic, electromagnetic insulation, as shielding protection or against radiation of any type.

2. A device, according to the previous claim, **characterized in that** a mesh (3) like a grid can be arranged in this relief, which mesh contributes to the fixing of the coating cement or mortar (6).

3. A device, according to the previous claims, **characterized in that** the reinforcements have holes (12) in their panels with a diameter sufficient for the cement of both outer faces to make contact, in which optionally wrought iron which bent as if they were clamp to attach the ends (7) can be introduced.

4. The device according to the previous claims, **characterized in that** the section of the grooves (11) existing in the faces of the outer panels (1), through which the cement (6) is introduced, has a section according to the Greek letter omega.

5. The device according to the previous claims, **characterized in that** the profiles (2) surrounding each panel have a section according to the Greek letter omega, in which the central slot corresponds to the thickness of the panel (1) fitted therein, whereas the side ends (22) project perpendicularly to the reinforcement, serving as a rule in the plastering, being adjusted to the suitable thickness and breadth of the cement or mortar to be placed.

6. The device according to the previous claims, **characterized in that** the profiles (2) are not smooth and have holes or small orifices (21) so that the cement is secured therein.

7. The device according to the previous claims, **characterized in that** the profiles (2) are assembled to one another by means of squares (4) fitted at the outside, which squares have an anchoring means formed by a toothed tab (23) which is supported on the base of the profile (2), which tab, upon being introduced, is fitted on saw-toothed notches (41) made in the outer base of the squares (4).

8. The device according to the previous claims, **characterized in that** both the profiles (2) and the squares (4) have flanges (25-42) which are orthogonally bent to be supported on the concrete surface or another panel, for the purpose of being locked by means of blocks and screws.

9. The device according to the previous claims, **characterized in that** the openings (24) allowing the passage in the profiles of electricity and plumbing supply lines are formed by a series of successively annexed and inverted triangles, with a gap between them, for the purpose of preventing a weakening of the inner structure of the profile, while at the same time they allow enlarging the necessary opening by simply removing the separation gap between every two triangles.

10. The device according to the previous claims, **characterized in that** the anchoring between reinforcements is carried out by means of rivets (8) made in the profiles upon joining and placing the reinforcements.

11. The device according to the previous claims, **characterized in that** in the areas in which there are no profiles (2-4) to facilitate the plastering of the reinforcements, rules with spikes are used which can be driven into and supported on the surface of the reinforcements (1) to form a guide rule for the plastering of the surface.

12. The device according to the previous claims, **characterized in that** an open U-shaped profile is arranged to facilitate the plastering of the edge of a reinforcement, the central part of which profile is supported on that of the profile of the reinforcement and is riveted for the purpose of serving as a rule according to the orthogonal emergence of the omega-shaped profiles.

13. The device according to the previous claims, **characterized in that** when two reinforcements are faced in a corner, an arrow tip-shaped corner profile (5) is arranged, the central segment of which is arranged in the diagonal dividing each plasterwork face according to the orthogonal emergence of the omega-shaped profiles, for the purpose of serving as a rule and facilitating the plastering of the reinforcements.

14. A method for assembling the device of the previous claims, **characterized in that** said reinforcements are installed in a new construction by fixing them to the ceiling, such that they are plumbed and hung and the lower movement is corrected on the flooring or floor.
